# EUROPEAN PATENT APPLICATION

(11) **EP 4 834 576 A1**
(43) Date of publication of application: **04.11.2026**
(21) Application number: 24911912.4
(22) Date of filing: 07.10.2024
(51) Int. Cl.: B32B 3/30, B32B 9/00, C23C 14/08, C23C 14/58

(54) **WATER-REPELLENT OBJECT, WATER-REPELLENT COMPONENT, AND METHOD FOR PRODUCING WATER-REPELLENT OBJECT**

(30) Priority: 28.12.2023 JP 2023222539
(71) Applicant: Towa Corporation, Kyoto-shi, Kyoto 601-8105 (JP)
(72) Inventor: KISHIMOTO, Tomoko, Kyoto-shi, Kyoto 601-8105 (JP)
(74) Representative: Winter, Brandl - Partnerschaft mbB
(86) International application number: PCT/JP2024/035786
(87) International publication number: WO 2025/142018

(57) **Abstract**

A water-repellent body (1) includes: a substrate (metal coating (3)) with an uneven structure (30); and a coating (4) covering the uneven structure (30), the coating (4) including: a water-repellent section (6) including a fluorine compound; and a close contact section (5) in close contact with the substrate (metal coating (3)), the close contact section (5) being made of a mixture including silicon dioxide and yttrium oxide.

## Description

### Technical Field

This disclosure relates to a water-repellent body, a water-repellent component, and a method for producing a water-repellent body.

### Background Art

A known water-repellent body includes a water-repellent coating on a surface of the object to prevent water droplets, dust, or the like from adhering to a surface of the object (see, for example, Patent Literature 1). Such a water-repellent body, which has a large contact angle with water and easily repels water droplets and the like, is in use for car bodies and camera lenses, for example, as they require water repellency.

Patent Literature 1 discloses a water-repellent body including a substrate and a coating disposed on the substrate, the coating includes a fluorocarbon resin, hydrophilic silica particles, and hydrophobic silica particles. The fluorocarbon resin and the hydrophilic silica particles serve to bond the coating to the substrate.

### Citation List

### Patent Literature

Patent Literature 1
WO 2016/181676 A1

### Summary of Invention

### Technical Problem

The water-repellent body of Patent Literature 1 involves the following issue: The water-repellent coating is weakly bonded to the substrate and easily detachable from the substrate due to friction or the like. The water-repellent body can easily lose its water repellency.

The above circumstances have led to a demand for a highly durable, highly water-repellent body including a coating (or water-repellent section) with reduced detachability.

### Solution to Problem

A water-repellent body as an embodiment of this disclosure includes: a substrate with an uneven structure; and a coating covering the uneven structure, the coating including: a water-repellent section including a fluorine compound; and a close contact section in close contact with the substrate, the close contact section being made of a mixture including silicon dioxide and yttrium oxide.

A water-repellent component as an embodiment of this disclosure includes: a water-repellent body; and a coating target with a surface on which the water-repellent body is present.

A method as an embodiment of this disclosure for producing a water-repellent body includes: forming an uneven structure on a surface of a substrate; forming on a surface of the uneven structure a close contact section made of a mixture including silicon dioxide and yttrium oxide; and forming on a surface of the close contact section a water-repellent section including a fluorine compound.

### Advantageous Effects

This disclosure may be embodied as a highly durable, highly water-repellent body including a water-repellent section with reduced detachability, a water-repellent component including a water-repellent body, and a method for producing a water-repellent body.

### Brief Description of Drawings

Fig. 1 is a diagram illustrating a vertical cross section of a water-repellent component.
Fig. 2 is an SEM image of a surface of an uneven structure.
Fig. 3 is an SEM image of a vertical cross section of a metal coating.
Fig. 4 is a diagram illustrating a method for producing a water-repellent body and a water-repellent component.
Fig. 5 is a diagram illustrating a vertical cross section of a water-repellent body.
Fig. 6 is a diagram illustrating a method for producing a water-repellent body.
Fig. 7 is a graph that shows water contact angles for Examples.
Fig. 8 is a graph that shows water sliding angles for Examples.

### Description of Embodiments

The description below deals with a water-repellent body as embodiments of this disclosure with reference to drawings. The embodiments described below are mere examples for describing this disclosure. This disclosure is not limited to the embodiments. This disclosure may be embodied variously without departing from the scope of this disclosure.

### [First Embodiment]

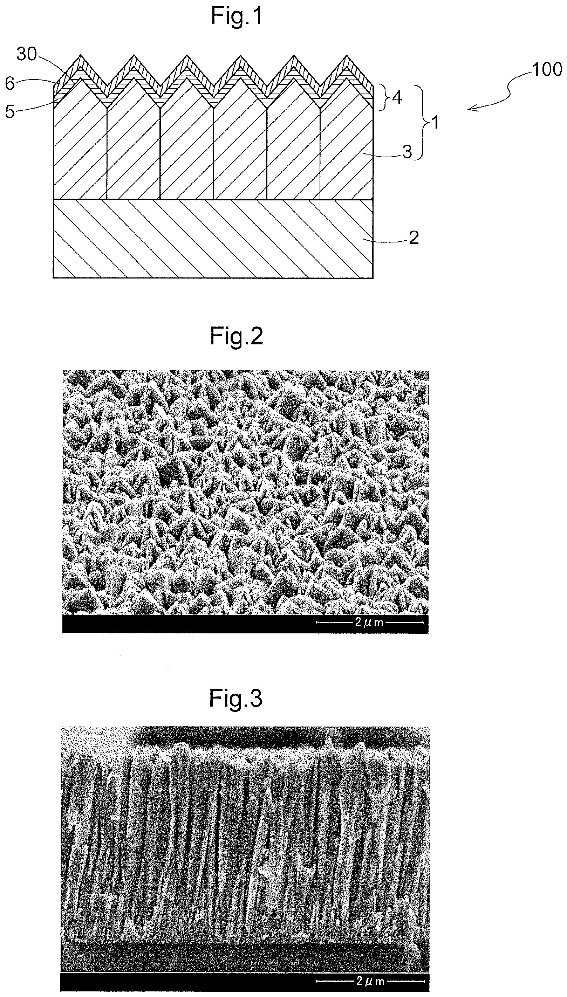

Fig. 1 is a vertical cross-sectional view of a water-repellent component 100 for the present embodiment including a water-repellent body 1 and a coating target 2. The water-repellent component 100 is not limited to any particular one, and is a component of any of various products that require water repellency. The coating target 2 is, for example, a metal such as aluminum, iron, or the like, glass, or ceramic. While the coating target 2 illustrated in Fig. 1 includes a single layer, the coating target 2 is not limited to a single-layer material, and may be a stack of two or more layers. In such a case, the layers may be identical to or different from each other. The coating target 2 may be, for example, of the body or a doorknob of an automobile. The water-repellent body 1 is on a surface of the coating target 2.

The water-repellent body 1 includes a metal coating 3 (which is an example substrate) and a coating 4. The metal coating 3 is made of a metal such as titanium or chromium, and has a thickness of 1 µm to 5 µm. The metal coating 3 has an uneven structure 30 on a surface opposite to the surface of contact with the coating target 2.

Fig. 2 is a scanning electron microscope (SEM) image of the surface of the uneven structure 30. Fig. 3 is an SEM image of a vertical cross section of the metal coating 3. As illustrated in Figs. 2 and 3, the metal coating 3 is made of columnar crystals, the respective pointed tips of which are defined as an uneven structure 30. While the metal coating 3 in Figs. 2 and 3 is made of chromium, the metal coating 3 may be made of another metal.

The uneven structure 30 desirably has protrusions and depressions that differ in height from each other by, for example, 10 nm to 5 µm. The height difference specifically refers to the difference in height between the peak of each protrusion and the bottom of each depression. An excessively large height difference will decrease the strength of the uneven structure 30 and render the uneven structure 30 easily breakable, whereas an excessively small height difference will result in a failure to achieve high water repellency (described later). The difference should preferably be from 100 nm to 3 µm. Such an uneven structure 30, which is a fine structure, would be easily breakable by contact with, for example, a human hand. In view of that, the uneven structure 30 is made of metal, and has high hardness as compared to an uneven structure made of, for example, resin. This improves the durability.

As illustrated in Fig. 1, the uneven structure 30 is covered by a coating 4 including a close contact section 5 in close contact with the uneven structure 30 and a water-repellent section 6 on a surface of the close contact section 5. The coating 4 is on a surface of the uneven structure 30 such that the close contact section 5 and the water-repellent section 6 are stacked in this order.

The close contact section 5 is made of a mixture containing silicon dioxide (silica) and yttrium oxide (yttria). The silicon in the close contact section 5 has high affinity for and forms a stable bond with fluorine (described later) in the water-repellent section 6. This allows the close contact section 5 to be in close contact with the water-repellent section 6, and can prevent the water-repellent section 6 from being detached from the uneven structure 30.

Yttria is contained in the close contact section 5. Yttria can improve the hardness of silica by being added to it. The close contact section 5 has high hardness and high durability, as compared to hydrophilic silica particles for typical use as an adhesive. Covering the surface of the uneven structure 30 with the close contact section 5 can protect the uneven structure 30, thereby further improving the durability of the uneven structure 30. The close contact section 5 contains yttria at any particular proportion. The lower limit should, for example, preferably be not lower than 1.0 mol%, more preferably not lower than 1.1 mol%. The upper limit should, for example, preferably be lower than 10 mol%, more preferably lower than 6 mol%, to ensure close contact with the uneven structure 30. The close contact section 5 desirably has a thickness of 5 nm to 90 nm, and should preferably have a uniform thickness on the surface of the uneven structure 30.

The yttrium atoms in the close contact section 5 may be partially substituted with atoms of a Group 4A element, which is not limited to any particular one, and may be, for example, at least one (that is, one or a combination of two or more) selected from the group consisting of titanium, zirconium, and hafnium, particularly preferably zirconium. The substitution strengthens the atomic bonds in the close contact section 5, and should harden the close contact section 5 as compared to the case of the yttrium atoms being not partially substituted. This renders the uneven structure 30 scratch-resistant and improves its durability.

The yttrium atoms in the close contact section 5 may be partially substituted with atoms of a Group 4A element at any proportion over 0. In other words, the close contact section 5 may contain atoms of a Group 4A element at any proportion over 0. The upper limit may be, for example, 20 mol%, 15 mol%, 10 mol%, or 5 mol%.

The oxygen atoms in the yttria may be partially substituted with nitrogen atoms. Nitrogen atoms bond with yttrium atoms more strongly than oxygen atoms bonding with yttrium atoms. Substituting a portion of the oxygen atoms in the yttria with nitrogen atoms strengthens the close contact section 5 and hence the water-repellent body 1, which includes the close contact section 5.

The oxygen atoms in the yttria in the close contact section 5 may be partially substituted with nitrogen atoms at any proportion over 0. In other words, the close contact section 5 may contain nitrogen atoms at any proportion over 0. The proportion may be 1 at%. The upper limit may be, for example, 10 at%, 5 at%, 3 at%, or 2 at%.

The water-repellent section 6 is on a surface of the close contact section 5. The water-repellent section 6 contains a fluorine compound, which desirably has a difluoromethyl group and may have, for example, silicon, oxygen, or the like. As described above, the silicon atoms in the close contact section 5 bond stably with fluorine atoms in the water-repellent section 6, so that the water-repellent section 6 is in close contact with the close contact section 5. The fluorine atoms and carbon atoms in the water-repellent section 6 bond stably with each other. This means weak forces acting between the molecules and a low surface free energy for the water-repellent section 6, with the result of the water-repellent section 6 having water repellency. The water-repellent section 6 desirably has a thickness of 5 nm to 90 nm, and should preferably have a uniform thickness on the surface of the close contact section 5 (or the uneven structure 30).

The water-repellent body 1 and a water droplet on its surface have a contact area equal to the area of contact between the tips of the uneven structure 30 and the water droplet. The uneven structure 30 thereby reduces the area of contact between the water-repellent body 1 and a water droplet. Forming a water-repellent section 6 (which has water repellency) over the surface of the uneven structure 30 imparts high water repellency to the water-repellent body 1. The water-repellent body 1 as the present embodiment has high water repellency thanks to the combination of the uneven structure 30 and the water-repellent section 6. The water-repellent body 1 prevents water from spreading across its surface, and is usable for the surface of a glass lens or of a motion sensor mounted in an automobile, for example.

### [Method for Producing Water-Repellent Body]

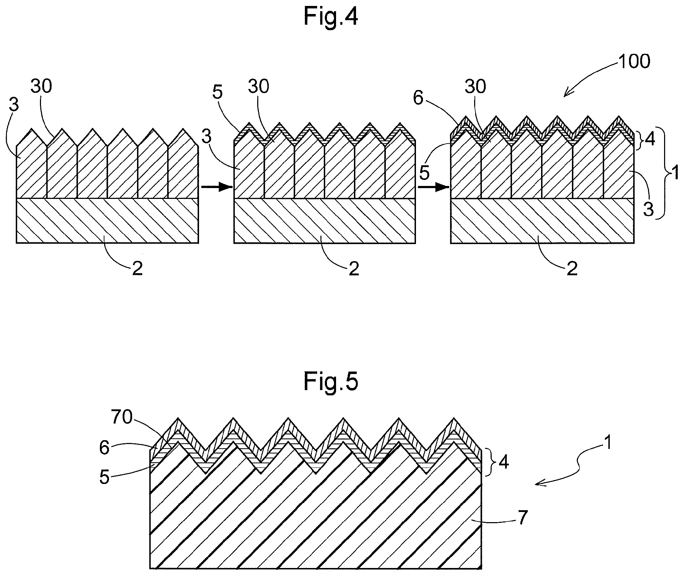

The description below deals with a method for producing a water-repellent component 100 and a water-repellent body 1 with reference to Fig. 4. First, an uneven structure forming step for forming a metal coating 3 and an uneven structure 30 on a surface of a coating target 2 is performed. The uneven structure forming step is performed by sputtering, and can use, for example, titanium or chromium as a target. Using sputtering gas with an excessively low pressure during the uneven structure forming step will result in a smooth metal coating 3 on the surface of the coating target 2, failing to produce an uneven structure 30. The uneven structure forming step is thus desirably performed to form an uneven structure 30 under a medium to high pressure (for example, not lower than 1 Pa). Using sputtering as above allows formation of a strong uneven structure 30.

The uneven structure forming step may alternatively be performed by sputtering in any manner different from the above, and may be, for instance, performed by sputtering in a manner similar to or conforming to a conventional one.

Then, a close contact section forming step for forming a close contact section 5 on a surface of the uneven structure 30 is performed. This step may be performed by any method, for example, (i) a method classified as physical vapor deposition such as vacuum deposition, sputtering, ion plating, or ion beam deposition or (ii) a method classified as chemical vapor deposition such as atomic layer deposition or plasma CVD. Vapor deposition forms a film at high speed, but the film tends to have low hardness or be soft. Sputtering forms a film at low speed, but the film tends to have high hardness or be hard. The close contact section forming step for the present embodiment should preferably use sputtering to strengthen the uneven structure 30. Sputtering allows formation of a uniform close contact section 5 on the surface of the uneven structure 30.

The close contact section forming step can use a mixture of silica and yttria as a target. This allows formation of a uniform close contact section 5 on the surface of the uneven structure 30, and thereby allows the water-repellent section 6 to be in close contact with the uneven structure 30. The yttrium atoms in the mixture may be partially substituted with atoms of a Group 4A element such as zirconium.

The close contact section forming step may be performed by, for example, reactive sputtering, that is, a method of sputtering in an atmosphere of argon with added nitrogen to further substitute a portion of the oxygen atoms in the yttria in the close contact section 5 with nitrogen atoms.

The close contact section forming step may be performed by sputtering in any manner, and may be, for instance, performed by sputtering in a manner similar to or conforming to a conventional one. Sputtering for film formation should be performed preferably at a speed not excessively low in terms of production efficiency and not excessively high in terms of the hardness of the close contact section 5.

Finally, a water-repellent section forming step for forming a water-repellent section 6 on a surface of the close contact section 5 is performed. This step may be performed by any method, for example, a plasma gas treatment method such as atmospheric pressure plasma treatment or corona treatment.

The water-repellent section forming step involves a fluorine compound such as (i) a perfluorocarbon such as carbon tetrafluoride or perfluorocyclobutane, (ii) trifluoromethane, (iii) a hydrofluorocarbon such as difluoromethane, (iv) sulfur hexafluoride, or (v) nitrogen trifluoride. The water-repellent section forming step converts any of these gases into plasma to generate fluorine-based activated species. The close contact section 5 holds a coating derived from the fluorine-based activated species, which decreases the surface free energy of the water-repellent body 1. This imparts high water repellency to the water-repellent body 1.

The water-repellent section forming step may involve plasma gas treatment being performed in any manner, for example, in a manner similarly to or conforming to a conventional one. The uneven structure forming step, the close contact section forming step, and the water-repellent section forming step may be performed through an integrated process.

### [Second Embodiment]

The description below deals with a water-repellent body 1 as a second embodiment with reference to Fig. 5. The water-repellent body 1 includes a flexible resin film 7 (which is an example substrate) with an uneven structure 70, which is present continuously on a surface of the resin film 7 for the present embodiment as illustrated in Fig. 5. The water-repellent body 1 includes a close contact section 5 and a water-repellent section 6 disposed in this order over a surface of the uneven structure 70. The second embodiment is otherwise configured similarly to the first embodiment. The description below omits to deal with such similar configurations.

The uneven structure 70, which is part of the resin film 7, is less strong and more easily breakable than the uneven structure 30 for the first embodiment, which is made of metal or the like. The present embodiment ensures the strength of the uneven structure 70 with a close contact section 5 covering the uneven structure 70.

The resin film 7 may be made of any flexible resin, for example, a thermoplastic resin, a thermosetting resin, or a photo-curable resin. Examples of the thermoplastic resin include polyethersulfone resins, polycarbonate resins, acrylic resins, polyethylene terephthalate resins, polyester resins such as polyethylene naphthalate resins, unsaturated polyester resins, polyolefin resins, cyclic olefin resins such as a norbornene resin, polyimide resins, polyamide resins, polyimide-amide resins, polyalylate resins, polysulphone resins, and polyetherimide resins. Examples of the thermosetting resin include phenol resins, epoxy resins, and urethane resins. Examples of the photo-curable resin include acrylic resins and epoxy resins. The resin film 7 should preferably be made of a thermoplastic resin, a thermosetting resin, a photo-curable resin, or the like in terms of formability of the uneven structure 70. The resin film 7 may be made of a heat-resistant resin depending on the desired performance of the water-repellent body 1.

The resin film 7 has a thickness of, for example, 100 nm to 1 mm. Bonding such a thin resin film 7 to a surface of a coating target (that is, an article or the like to be rendered water-repellent) allows the water-repellent body 1 to impart water repellency to the coating target even if the coating target has a complex shape. The water-repellent body 1 imparts high water repellency also to an object with a large area. The water-repellent body 1 imparts water repellency to any of various articles. Continuously joining two or more resin films 7 results in a film roll with high water repellency.

The resin film 7 may or may not be colored. Using a colored resin film 7 results in a colored water-repellent body 1 and allows the appearance of the water-repellent body 1 to be selected from among a wider range of design options. Further, the resin film 7 may have translucency so as not to block light or the like from a coating target when fixed to its surface. The water-repellent body 1 is easily usable for existing products and the like and can impart water repellency to any of various objects.

The resin film 7 may be bonded to a surface of a coating target with use of any adhesive capable of fixing the resin film 7, for example, an acrylic resin or a polyester resin.

### [Method for Producing Water-Repellent Body]

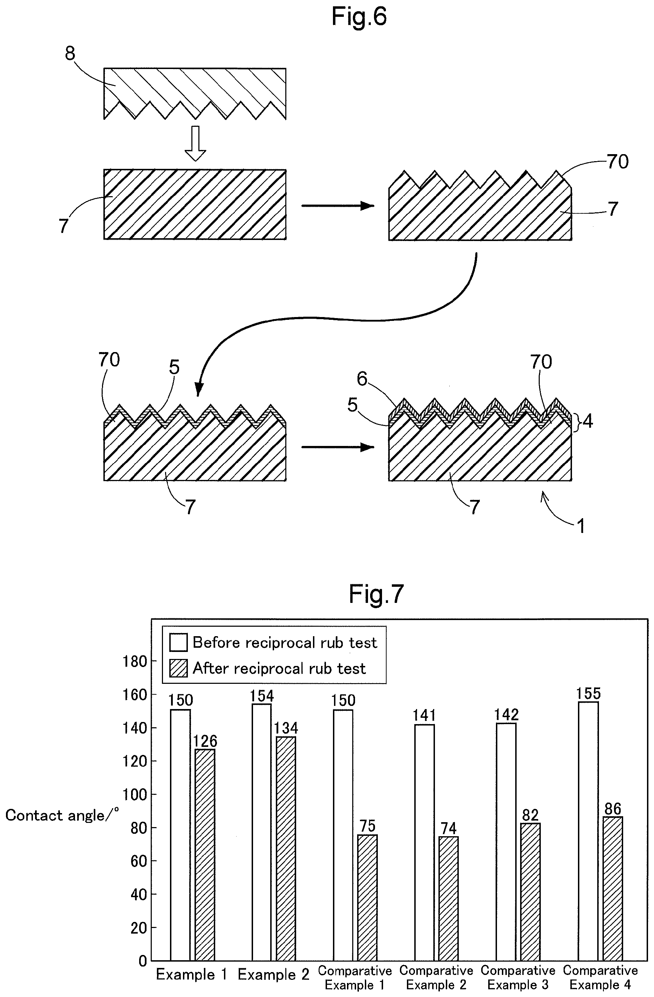

The description below deals with a method for producing a water-repellent body 1 with reference to Fig. 6. First, an uneven structure forming step for forming an uneven structure 70 on a surface of the resin film 7 by pressing a molding die 8 against the resin film 7 to transfer an uneven structure 70 to the resin film 7 is performed.

The molding die 8 is, for example, a die so shaped as to transfer an uneven structure 70. The molding die 8 has been processed by, for example, etching, laser processing, or electroforming so as to form an uneven structure 70 similar to the uneven structure 30. The molding die 8 should preferably be prepared by electroforming for highly accurate formation of the very fine uneven structure 70. The molding die 8 should desirably be prepared with use of the uneven structure 30, which is formed by sputtering for the first embodiment.

The transfer is based on, for example, thermal imprinting, UV imprinting, nano-casting, reversal imprinting, or roll-to-roll process. Thermal imprinting involves a heat cycle and has poor production efficiency, but is usable to process various materials. UV imprinting advantageously enables quick and efficient transfer. The present embodiment uses any method.

Preparing a resin film 7 from a thermoplastic resin involves heating and softening a thermoplastic resin, clamping the thermoplastic resin with use of the molding die 8 (that is, pressing the molding die 8 against the thermoplastic resin), then cooling the thermoplastic resin, and releasing the molding die 8. This allows the resin film 7 to have an uneven structure 70. Preparing a resin film 7 from a thermosetting resin should desirably involve clamping a liquid thermosetting resin with use of the molding die 8 and then heating the thermosetting resin. Heating the thermosetting resin cures the thermosetting resin. The preparation then involves releasing the molding die 8. This allows the resin film 7 to have an uneven structure 70. Preparing a resin film 7 from a photo-curable resin should desirably involve applying a liquid thermosetting resin to a surface of a coating target, clamping the photo-curable resin with use of a transparent molding die 8, and irradiating the photo-curable resin with light to cure the photo-curable resin. The preparation then involves releasing the molding die 8. This allows the resin film 7 to have an uneven structure 70. The preparation may alternatively involve irradiating a liquid photo-curable resin with light to cure the photo-curable resin to an extent, clamping the photo-curable resin with use of a non-transparent molding die 8, then releasing the molding die 8, and further irradiating the photo-curable resin with light to fully cure the photo-curable resin.

Then a close contact section forming step for forming a close contact section 5 on a surface of the uneven structure 70 is performed. And then a water-repellent section forming step for forming a water-repellent section 6 on a surface of the close contact section 5 is performed. These steps are similar to those for the first embodiment and are not detailed here.

The water-repellent body 1 includes a close contact section 5 and a water-repellent section 6 over a resin film 7. For example, by applying an acrylic resin or polyester resin as an adhesive, the water-repellent body 1 may be fixed to a surface of a coating target. The adhesive bonds the water-repellent body 1 to the coating target. This fixes the water-repellent body 1 to the surface of the coating target and imparts the high water repellency of the water-repellent body 1 to the coating target. The adhesive may alternatively be applied to that surface of the water-repellent body 1 which comes into contact with the coating target. If the method includes applying a liquid thermosetting or photo-curable resin to the coating target, clamping the resin, and heating the resin or irradiating the resin with light to cure the resin, curing the resin results in a resin film 7 fixed to the surface of the coating target. This eliminates the need to fix the water-repellent body 1 with use of an adhesive.

### [Examples]

The description below deals with Examples of this disclosure. This disclosure is not limited to the Examples.

### (Example 1)

Example 1 was prepared by the method of this disclosure for producing a water-repellent body. First, the uneven structure forming step was performed to form a metal coating 3 with an uneven structure 30 on a surface of a coating target 2 by sputtering with use of a sputtering device (E-200S from Canon Anelva Corporation). The step used a direct-current power supply with an input power of 150 W. The step used chromium as a target for forming a metal coating 3 and argon as a sputtering gas. The step involved sputtering under medium to high pressure and heating a substrate at temperatures within the range of room temperature to 200°C to form a metal coating 3 with an uneven structure 30. The step produced a metal coating 3 with a thickness of 2.5 µm.

Then, the close contact section forming step was performed to form a close contact section 5 on a surface of the uneven structure 30 by sputtering with use of a sputtering device (E-200S from Canon Anelva Corporation). The step used an RF power supply with an input power of 75 W. The step used as a target for forming a close contact section 5 a ceramic material with a sintered density of 65% to 98% in the form of a mixture of silica and yttria. The step prepared the ceramic material by hot-pressing silica and yttria in a multipurpose high-temperature furnace (High Multi 5000 from Fujidempa Kogyo Co., Ltd.). The step used argon as a sputtering gas and formed a close contact section 5 at room temperature under low pressure. The step produced a close contact section 5 with a thickness of 30 nm.

Finally, the water-repellent section forming step was performed to form a water-repellent section 6 on a surface of the close contact section 5 by plasma gas treatment with use of a reactive ion etching device (RIE-400iPB from Samco Inc.). The step used an ICP power of 100 W to 1000 W as well as perfluorocyclobutane and oxygen as gases. The step had a gas pressure of 1 Pa to 10 Pa and a temperature range of room temperature to 70°C for the treatment to form a water-repellent section 6. The step produced a water-repellent section 6 with a thickness of 50 nm.

### (Example 2)

A water-repellent body 1 was prepared similarly to Example 1 except that the close contact section forming step used a ceramic material in the form of a mixture of silica, zirconia, and yttria as a target for forming a close contact section 5 and argon and nitrogen as sputtering gases. Example 2 had yttrium atoms substituted with zirconium atoms at a proportion of 5 mol% to 20 mol% and had a portion of the oxygen atoms in the yttria substituted with nitrogen atoms. Example 2 was prepared with use of a ceramic material with a sintered density of 65% to 98% prepared similarly to Example 1.

### (Comparative Example 1)

A water-repellent body 1 was prepared similarly to Example 2 except that the close contact section forming step used a ceramic material in the form of a mixture of zirconia and yttria as a target for forming a close contact section 5. Comparative Example 1 had yttrium atoms substituted with zirconium atoms at a proportion of 5 mol% and had a portion of the oxygen atoms in the yttria substituted with nitrogen atoms. Comparative Example 1 was prepared with use of a ceramic material with a sintered density of 65% to 98% prepared similarly to Example 1.

### (Comparative Example 2)

A water-repellent body 1 was prepared similarly to Comparative Example 1 except that this Comparative Example had yttrium atoms substituted with zirconium atoms at a proportion of 10 mol%.

### (Comparative Example 3)

A water-repellent body 1 was prepared similarly to Comparative Example 1 except that this Comparative Example had yttrium atoms substituted with zirconium atoms at a proportion of 20 mol%.

### (Comparative Example 4)

A commercially available water-repellent film (Leafy LF-4362 from Soken Chemical & Engineering Co., Ltd.) was used as Comparative Example 4.

Comparative Examples 1 to 3 each used a ceramic material in the form of a mixture of zirconia and yttria as a target for forming a close contact section 5. This ceramic material is in use also as a target for coating a CBN tool. CBN stands for cubic boron nitride and refers to a sintered body made of boron and nitrogen. CBN tools are in use to cut, for example, high-hardness steel as they have hardness second only to diamond, high thermal conductivity, and stability at high temperatures. While CBN tools have high abrasion resistance, there is a demand for CBN tools with longer life. Coating the surface of a CBN tool with a mixture containing zirconia and yttria imparts further oxidation resistance to the CBN tool for longer life. Forming the above coating on, for example, a φ1.0 radius end mill extends its life by 128% with respect to HRC50 materials (for example, SKD11), by 143% with respect to HRC55 materials (for example, STAVAX), and by 155% with respect to HRC60 materials (for example, ELMAX). The above coating may be formed on a CBN tool in a manner similar to the close contact section forming step for Example 1, desirably with a sputtering temperature of not lower than 200°C.

The durability of each of Examples 1 and 2 and Comparative Examples 1 to 4 was determined by reciprocally rubbing the surface of the water-repellent body 1 to measure its water contact angle and water sliding angle before and after the reciprocal rub test. The reciprocal rub test involved reciprocally rubbing the surface of the water-repellent body 1 1000 times with canvas fabric at a speed of 50 mm/s while applying a load of 500 g onto the surface.

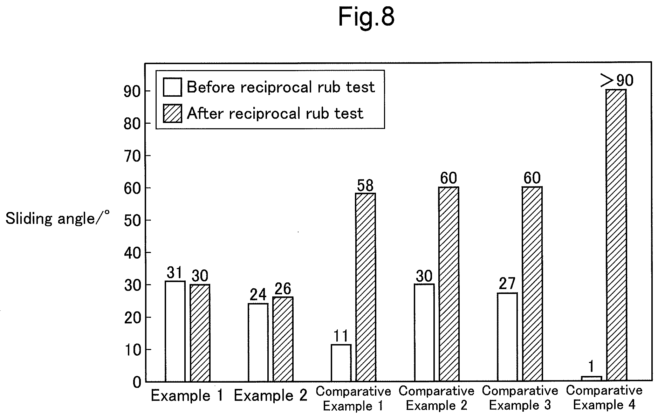

The contact angle was measured by dispensing 2 µL of water droplets onto the surface of each of Examples 1 and 2 and Comparative Examples 1 to 4. The sliding angle was measured by dispensing 20 µL of water droplets onto the surface of each of Examples 1 and 2 and Comparative Examples 1 to 4, inclining the water-repellent body 1 by 5°/s from 0° to 90°, and measuring the angle at which the water droplets slid off. Figs. 7 and 8 show the measurement results.

Fig. 7 shows the following: Examples 1 and 2 and Comparative Examples 1 to 4 each had a contact angle of larger than 140° before the reciprocal rub test and had high water repellency. The contact angle for each of Examples 1 and 2 did not change greatly through the reciprocal rub test. However, the contact angle for each of Comparative Examples 1 to 4 changed greatly through the reciprocal rub test; the contact angle after the test was approximately half the contact angle before the test. This indicates that the water-repellent body 1 according to this disclosure is so durable as not to lose its water repellency due to friction.

Fig. 8 shows the following: The sliding angle for each of Examples 1 and 2 did not change greatly through the reciprocal rub test; the sliding angle for Example 1 remained at around 30°, whereas that for Example 2 remained at around 25°. The water-repellent body 1 of each of Examples 1 and 2 would prevent adhesion of water droplets to its surface if inclined at around 25° to 30° even after the reciprocal rub test. The sliding angle for each of Comparative Examples 1 to 4, on the other hand, changed greatly through the reciprocal rub test; the sliding angle after the test for Comparative Example 1 was approximately five times that before the test, and the sliding angle after the test for each of Comparative Examples 2 and 3 was approximately twice that before the test. This indicates that the water-repellent body 1 has improved abrasion resistance if the close contact section 5 contains silica. Comparative Example 4 had a sliding angle of 1° before the reciprocal rub test and larger than 90° after the test, so that water droplets did not slide off. This indicates that the water-repellent body 1 according to this disclosure is so durable as not to lose its water repellency due to friction.

### [Summary of Above Embodiments]

The description below summarizes the water-repellent body 1, the water-repellent component 100, and the method for producing a water-repellent body 1 each described above as an embodiment.
(1) A water-repellent body (1) characteristically includes: a substrate (metal coating (3), resin film (7)) with an uneven structure (30, 70); and a coating (4) covering the uneven structure (30, 70), the coating (4) including: a water-repellent section (6) including a fluorine compound; and a close contact section (5) in close contact with the substrate (metal coating (3), resin film (7)), the close contact section (5) being made of a mixture including silicon dioxide and yttrium oxide.
   With the above configuration, the uneven structure (30, 70) reduces the area of contact between the substrate (metal coating (3), resin film (7)) and water droplets and the like, whereas the water-repellent section (6), which includes a fluorine compound, reduces the surface free energy of the uneven structure (30, 70). This imparts high water repellency to the substrate (metal coating (3), resin film (7)). The water-repellent section (6) would normally be easily detachable from the substrate (metal coating (3), resin film (7)) due to friction or the like. The close contact section (5), which is in close contact with the substrate (metal coating (3), resin film (7)), includes silica and is easily bonded to the fluorine compound in the water-repellent section (6). This increases the adhesion of the water-repellent section (6) to the close contact section (5) and can reduce the detachability of the water-repellent section (6). The close contact section (5), which includes yttria, has high hardness and can increase the durability of the uneven structure (30, 70). The above configuration thereby provides a durable water-repellent body (1).
(2) The water-repellent body (1) according to item (1) above may be further configured such that the mixture has a portion of yttrium atoms substituted with atoms of a Group 4A element.
   With the above configuration, the mixture has a portion of the yttrium atoms substituted with atoms of a Group 4A element that form an oxide higher in hardness than yttria. This strengthens the bond between the atoms included in the close contact section (5) and increases its hardness for the uneven structure (30, 70) to have increased durability.
(3) The water-repellent body (1) according to item (2) above may be further configured such that the Group 4A element is zirconium.
   With the above configuration, the mixture has a portion of the yttrium atoms substituted with zirconium atoms that form zirconia, which is higher in hardness than yttria. This strengthens the bond between the atoms included in the close contact section (5) and increases its hardness for the uneven structure (30, 70) to have further increased hardness.
(4) The water-repellent body (1) according to any one of items (1) to (3) may be further configured such that the uneven structure (30, 70) includes chromium.
   With the above configuration, the uneven structure (30, 70) includes chromium for increased strength. This increases the durability of the water-repellent body (1).
(5) The water-repellent body (1) according to any one of items (1) to (3) may be further configured such that the substrate is a resin film (7).
   With the above configuration, the flexible resin film (7) has a surface with an uneven structure (70). This can impart transparency and flexibility, for example, to the water-repellent body (1) and allows the appearance of the water-repellent body (1) to be selected from among a wider range of design options. Further, the resin film (7) is fixable to a surface of any object to impart high water repellency to even an object with a large area or any of various shapes. The water-repellent body (1) can thereby impart high water repellency to any of various objects.
(6) The water-repellent body (1) according to any one of items (1) to (5) may be further configured such that the fluorine compound includes a difluoromethyl group.
   With the above configuration, the fluorine atoms and carbon atoms in the difluoromethyl group bond stably with each other. This means weak forces acting between the molecules and a low surface free energy for the water-repellent section (6), with the result of the water-repellent section (6) having water repellency. Further, the fluorine atoms in the water-repellent section (6) tend to bond stably with the silicon atoms in the close contact section (5), allowing the water-repellent section (6) to be in close contact with the close contact section (5). This can prevent the water-repellent section (6) from being detached.
(7) A water-repellent component (100) characteristically includes: a water-repellent body (1) according to any one of items (1) to (5); and a coating target (2) with a surface on which the water-repellent body (1) is present.
   With the above configuration, the water-repellent component (100) includes a durable water-repellent body (1) on a surface of the coating target (2) and thereby does not easily lose its water repellency. The water-repellent component (100) maintains its water repellency over an extended period of time even if the water-repellent component (100) tends to be touched with a human hand or the like and subjected to friction.
(8) A method for producing a water-repellent body (1) characteristically includes: forming an uneven structure (30) on a surface of a substrate (metal coating (3), resin film (7)); forming on a surface of the uneven structure (30) a close contact section (5) made of a mixture including silicon dioxide and yttrium oxide; and forming on a surface of the close contact section (5) a water-repellent section (6) including a fluorine compound.
   The above method includes forming an uneven structure (30, 70) on a surface of a substrate (metal coating (3), resin film (7)). This can reduce the area of contact between the substrate (metal coating (3), resin film (7)) and water droplets and the like. The method also includes forming a close contact section (5) including yttria. Covering the uneven structure (30, 70) with the close contact section (5) for protection can further increase the durability of the uneven structure (30, 70). The method also includes forming on a surface of the close contact section (5) a water-repellent section (6) including a fluorine compound. This can reduce the surface free energy of the substrate (metal coating (3), resin film (7)) for high water repellency. Further, the close contact section (5) includes silicon, whereas the water-repellent section (6) includes fluorine. Silicon has high affinity for and bonds stably with fluorine. This allows the close contact section (5) to be in close contact with the water-repellent section (6) and prevents the water-repellent section (6) from being easily detached from the substrate (metal coating (3), resin film (7)). The above configuration thereby allows production of a durable water-repellent body (1).
(9) The method according to item (8) above may be further configured such that the mixture has a portion of yttrium atoms substituted with atoms of a Group 4A element.
   With the above configuration, the mixture has a portion of the yttrium atoms substituted with atoms of a Group 4A element that form an oxide higher in hardness than yttria. This strengthens the bond between the atoms included in the close contact section (5) and increases its hardness for the uneven structure (30, 70) to have increased durability.
(10) The method according to item (9) above may be further configured such that the Group 4A element is zirconium.
   With the above configuration, the mixture has a portion of the yttrium atoms substituted with zirconium atoms that form zirconia, which is higher in hardness than yttria. This strengthens the bond between the atoms included in the close contact section (5) and increases its hardness for the uneven structure (30, 70) to have increased durability.
(11) The method according to any one of items (8) to (10) may be further configured such that the forming of the uneven structure is based on a sputtering method.
   With the above configuration, the forming of the uneven structure is based on a sputtering method. This allows formation of an uneven structure (30) during the formation of the substrate (metal coating (3)).
(12) The method according to item (11) above may be further configured such that the forming of the uneven structure uses chromium as a target.
   With the above configuration, the uneven structure (30) includes chromium for increased strength.
(13) The method according to any one of items (8) to (10) may be further configured such that the forming of the uneven structure includes transferring the uneven structure (70) onto a flexible resin film (7).
   The above method includes pressing against a flexible resin film (7) a molding die (8) configured to form and transfer an uneven structure (70). This allows efficient formation of an uneven structure (70) onto a resin film (7) with a large surface area. Further, fixing the resin film (7) to a surface of an object or the like to be rendered water-repellent, for instance, imparts water repellency to the object even if the object cannot itself have an uneven structure (70). The water-repellent body (1) can impart high water repellency to even an object with a large area or any of various shapes. The water-repellent body (1) is thus usable for a wider range of objects. Further, the resin film (7) may be, for example, so transparent and/or flexible as to allow the appearance of the water-repellent body (1) to be selected from among a wider range of design options.
(14) The method according to any one of items (8) to (13) may be further configured such that the fluorine compound includes a difluoromethyl group.
   With the above configuration, the fluorine atoms and carbon atoms in the difluoromethyl group bond stably with each other. This means weak forces acting between the molecules and a low surface free energy for the water-repellent section (6), with the result of the water-repellent section (6) having water repellency. Further, the fluorine atoms in the water-repellent section (6) tend to bond stably with the silicon atoms in the close contact section (5), allowing the water-repellent section (6) to be in close contact with the close contact section (5). This can prevent the water-repellent section (6) from being detached.
(15) A water-repellent body (1) may be produced by a method according to any one of items (8) to (14).

The above configuration provides a highly durable, highly water-repellent body (1) including a water-repellent section (6) with reduced detachability.

### Industrial Applicability

This disclosure is applicable to a water-repellent body, a water-repellent component including the water-repellent body, and a method for producing a water-repellent body.

### Reference Signs List

- 1: Water-repellent body
- 2: Coating target
- 3: Metal coating (substrate)
- 4: Coating
- 5: Close contact section
- 6: Water-repellent section
- 7: Resin film (substrate)
- 30: Uneven structure
- 70: Uneven structure
- 100: Water-repellent component

## Claims

1. A water-repellent body, comprising:
a substrate with an uneven structure; and
a coating covering the uneven structure,
the coating including:
a water-repellent section including a fluorine compound; and
a close contact section in close contact with the substrate,
the close contact section being made of a mixture including silicon dioxide and yttrium oxide.

2. The water-repellent body according to claim 1, wherein
the mixture has a portion of yttrium atoms substituted with atoms of a Group 4A element.

3. The water-repellent body according to claim 2, wherein
the Group 4A element is zirconium.

4. The water-repellent body according to any one of claims 1 to 3, wherein
the uneven structure includes chromium.

5. The water-repellent body according to any one of claims 1 to 4, wherein
the substrate is a flexible resin film.

6. The water-repellent body according to any one of claims 1 to 5, wherein
the fluorine compound includes a difluoromethyl group.

7. A water-repellent component, comprising:
a water-repellent body according to any one of claims 1 to 6; and
a coating target with a surface on which the water-repellent body is present.

8. A method for producing a water-repellent body,
the method comprising:
forming an uneven structure on a surface of a substrate;
forming on a surface of the uneven structure a close contact section made of a mixture including silicon dioxide and yttrium oxide; and
forming on a surface of the close contact section a water-repellent section including a fluorine compound.

9. The method according to claim 8, wherein
the mixture has a portion of yttrium atoms substituted with atoms of a Group 4A element.

10. The method according to claim 9, wherein
the Group 4A element is zirconium.

11. The method according to any one of claims 8 to 10, wherein
the forming of the uneven structure is based on a sputtering method.

12. The method according to claim 11, wherein
the forming of the uneven structure uses chromium as a target.

13. The method according to any one of claims 8 to 10, wherein
the forming of the uneven structure includes transferring the uneven structure onto a flexible resin film.

14. The method according to any one of claims 8 to 10, wherein
the fluorine compound includes a difluoromethyl group.

15. A water-repellent body produced by a method according to any one of claims 8 to 14.
